Europäisches Patentamt

European Patent Office

Office européen des brevets

(11) Publication number : **0 392 367 B1**

# EUROPEAN PATENT SPECIFICATION

(45) Date of publication of patent specification :
**15.03.95 Bulletin 95/11**

(51) Int. Cl.⁶ : **G01R 31/34,** G01R 21/00

(21) Application number : **90106559.9**

(22) Date of filing : **05.04.90**

(54) **Load state decision apparatus of servomotor.**

(30) Priority : **11.04.89 JP 42111/89**

(43) Date of publication of application :
**17.10.90 Bulletin 90/42**

(45) Publication of the grant of the patent :
**15.03.95 Bulletin 95/11**

(84) Designated Contracting States :
**DE GB SE**

(56) References cited :
**GB-A- 2 122 749**
**I.E.E.E. TRANSACTIONS ON INDUSTRY AP-**
**PLICATIONS vol. 25, no. 1, January/February**
**1989, pages 113-117, New York, NY, US; J. DE**
**MEESTER et al.:"Microcomputer-controlled**
**torque calculator in DC drives"**

(73) Proprietor : **MITSUBISHI DENKI KABUSHIKI**
**KAISHA**
**2-3, Marunouchi 2-chome**
**Chiyoda-ku**
**Tokyo 100 (JP)**

(72) Inventor : **Nishimura, Makoto c/o Mitsubishi**
**Denki K.K.**
**Nagoya Works**
**1-14, Yada Minami 5 chome**
**Higashi-ku, Nagoya-shi Aichi (JP)**
Inventor : **Takase, Shigeaki c/o Mitsubishi**
**Elec. Engin.Co.Ltd**
**Nagoya-Jigyosho**
**1-14, Yada Minami 5 chome**
**Higashi-ku, Nagoya-shi Aichi (JP)**

(74) Representative : **Eisenführ, Speiser & Partner**
**Martinistrasse 24**
**D-28195 Bremen (DE)**

## Description

The invention relates to an apparatus for monitoring the load state of an electric motor, comprising means for detecting a load current value of said motor during operation; means for sampling the detected load current value at prescribed time intervals and for storing the sampled value as current value data in a memory; means for calculating an effective current value from the current value data and for comparing the calculated effective current value with a rated current value for deciding the load state.

From GB-A-2 122 749 an apparatus for monitoring the conditions of an electrically driven motor is known, comprising means for detecting and sampling the load current of the motor, means for comparing calculated values with reference values and testing the significance of these results. This known apparatus permits the monitoring of various data of an electric motor during test phases.

Moreover it is generally known to measure the load state of a servomotor during operation, i.e. for example the torque, power, delay, speed or the like by using a detecting apparatus. As a well-known means an oscilloscope is used, the wave forms are recorded and later compared with standard wave forms for obtaining a decision. The consumed power is measured by a watthourmeter or the like and divided by the measuring time to obtain the effective current to be compared with the rated current.

These methods require technical skill and knowledge of the user, and personal errors are likely to occur when making decisions. It is an object of the present invention to provide an apparatus for monitoring the load state of a servomotor without the necessity to use complicated equipment, and by which the results of the load state can be automatically obtained.

In order to attain the foregoing object, an apparatus for monitoring the load state of an electric motor as defined in the preamble of claim 1, is characterized in that the motor is a servomotor, the load state of which is controlled by a positioning apparatus and a servo control unit having data communication means respectively so that data can be transmitted and received mutually; and said monitoring apparatus further comprises a setting indicator including a start key and a stop key, the operation of the start key starting the writing of sampled current value data from the memory into a further memory and the operation of the stop key starting the reading of the current value data stored in the further memory, the calculation of the effective current value from the current value data and the comparison of the calculated effective current value with the rated current value for deciding the load state.

Preferable embodiments are defined in the dependent claims.

The above and further objects and novel features of the invention will more fully appear from the following detailed description when the same is read in connection with the accompanying drawings. It is to be expressly understood, however, that the drawings are for purpose of illustration only and are not intended as a definition of the limits of the invention.

FIG. 1 is a blode diagram of a servomotor positioning control system as an embodiment of the invention;

FIG. 2 is a timing chart illustrating a data sampling processing by an embodiment of the invention;

FIG. 3 is a flow chart illustrating a processing part A by an embodiment of the invention;

FIG. 4 is a flow chart illustrating a processing part B by an embodiment of the invention;

FIG. 5 is a flow chart illustrating the processing as a whole by an embodiment of the invention;

FIG. 6 is a chart illustrating a record organization within a memory of an embodiment of the invention;

FIG. 7 is a characteristic diagram illustrating an example of torque or current value of a servomotor; and

FIG. 8 is an explanation diagram illustrating the calculation of an effective value by an embodiment of the invention.

A preferred embodiments of the invention will now be described in detail referring to the accompanying drawings.

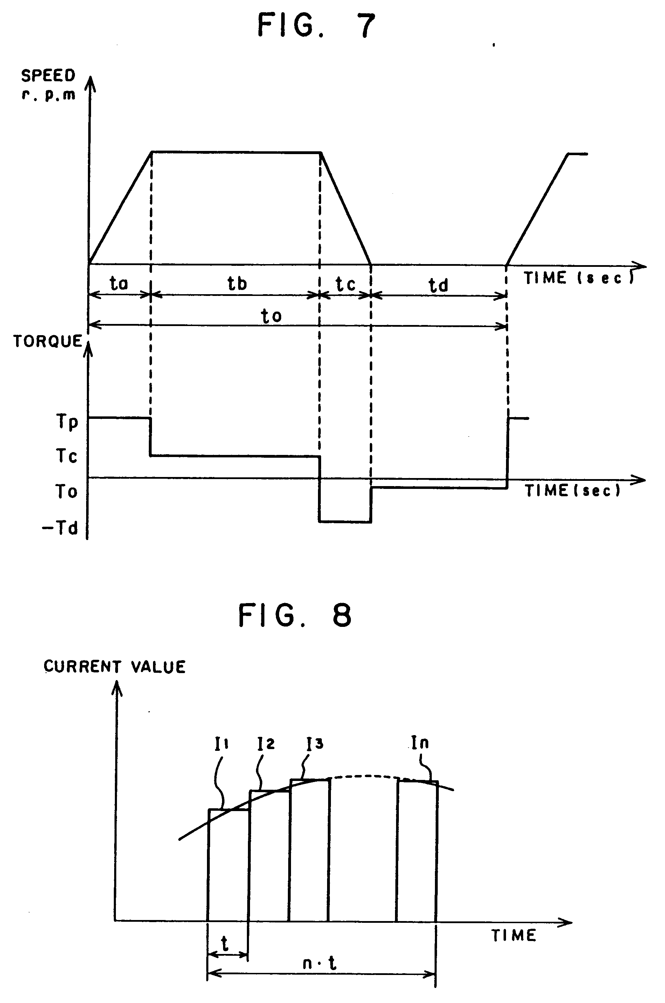

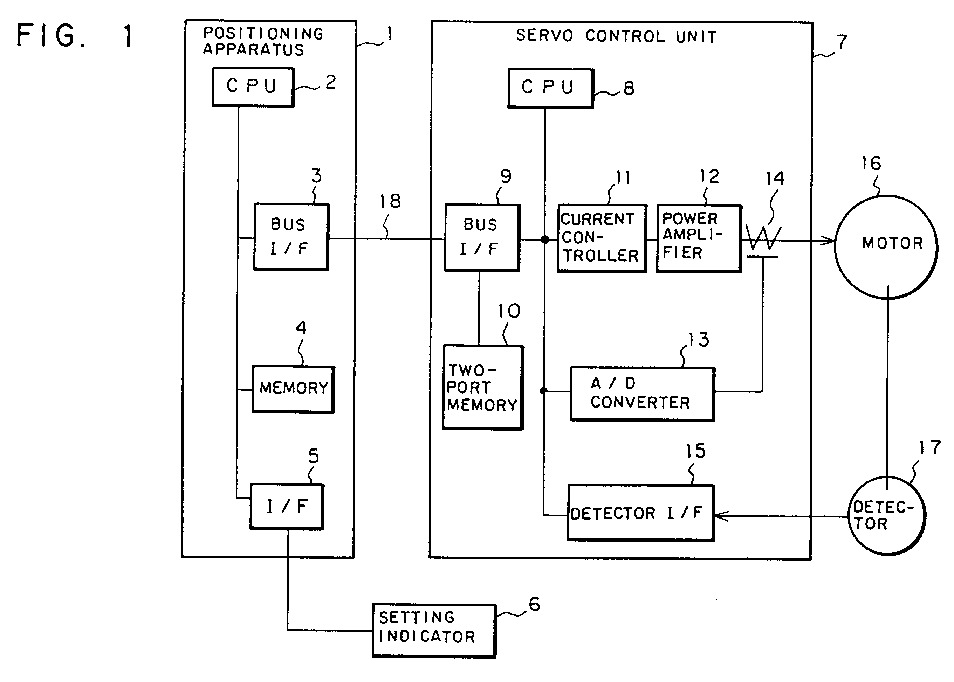

FIG. 1 shows a servomotor positioning control system as an embodiment of the invention. In FIG. 1, reference numeral 1 designates a positioning apparatus, numeral 2 designates a CPU of the positioning apparatus 1, numeral 3 designates a bus I/F for performing interface with a servo control unit 7, numeral 4 designates a memory for storing data read from two-port memory 10 of a servo control unit 7, numeral 5 designates an interface section (I/F section) to a setting indicator 6 having a display device and an operation key, numeral 7 designates a servo control unit, numeral 8 designates a CPU of the servo control unit 7, numeral 9 designates a bus I/F for performing interface with the positioning apparatus 1, numeral 10 designates a two-port memory capable of accessing the CPU 2 of the positioning apparatus 1 and the CPU 8 of the servo control unit 7, numeral 11 designates a current controller for controlling current supplied to a servo motor 16, numeral 12 designates a power amplifier for producing current supplied to a servo motor 16 according to a command of the current controller 11, numeral 13 designates an A/D converter where an analog value of current detected by a motor current detector 14 is converted into a digital value, numeral 14 designates a motor current detector for detecting the motor current transmitted from the power amplifier 12, numeral 15 designates a detector I/F for inputting the pulse signal outputted from a detector 17 and for calculating a position feedback value and a speed feedback value and transmitting the feedback values to the CPU 8, numeral 16 designates a servomotor, numeral 17 designates a detector for obtaining position information and speed information of the servomotor 16, and numeral 18 designates a bus cable connecting the positioning apparatus 1 and the servo control unit 7.

Next, operation will be described. As a general operation, a command is outputted from the positioning apparatus 1 according to a command of the setting indicator 6, and power is supplied from the servo control unit 7 to the motor 16 according to the command of the positioning apparatus 1, and thereby the motor 16 is rotated. The detector 17 is used for feeding back the state of position or speed of the motor 16 to the servo control unit 7. Current supplied to the motor 16 is detected by the motor current detector 14 and is converted into a digital quantity by the A/D converter 13 and fed back.

Next, operation of deciding the load state will be described. First, means are described for sampling the current value detected by the motor current detector 14 and for transferring the sampled value from the servo control unit 7 to the positioning apparatus 1.

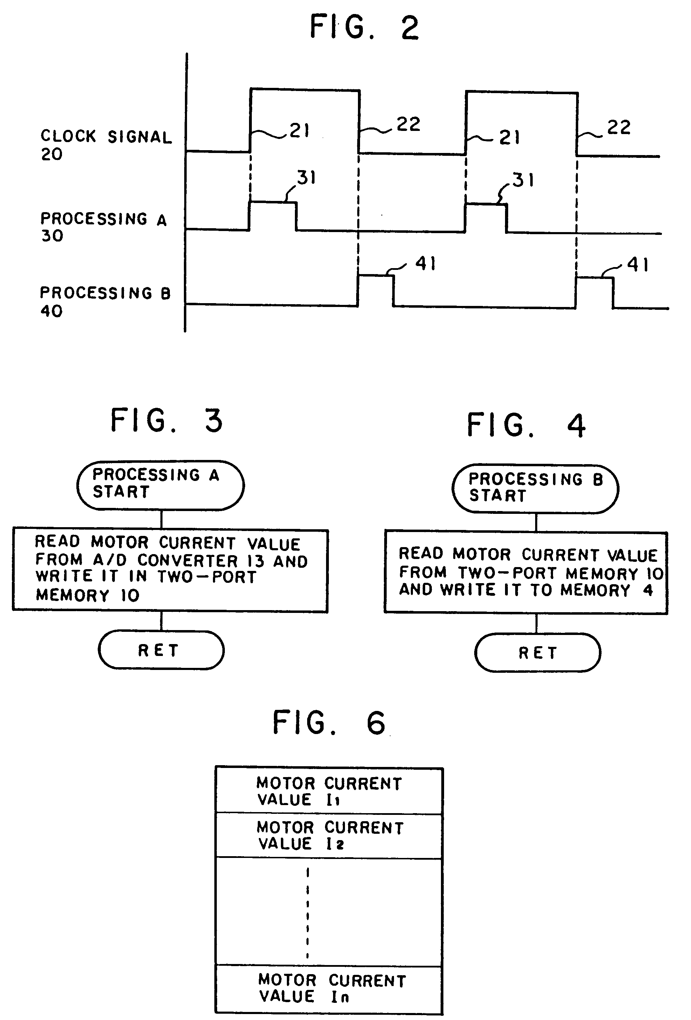

FIG. 2 shows the data sampling processing by an embodiment of the invention. In FIG. 2, a clock signal 20 is shown that is generated by a clock incorporated in the positioning apparatus 1, and which is outputted also to the servo control unit 7 through the bus cable 18. One period of the clock signal 20 is 3 - 5 ms, and data is transferred one time during this period.

Processing part A is that at the side of the servo control unit 7, and when the CPU 8 of the servo control unit 7 detects a rise 21 of the clock signal 20, the execution begins, and the period of the clock signal 20 is set so that the execution begins when the CPU 8 of the servo control unit 7 detects the rise 21 of the clock signal, and it is always finished before a fall 22 of the clock signal 20. Part designated by numeral 31 represents that the processing part A is being executed.

Content of the processing part A as shown in FIG. 3 is that a motor current value detected by the motor current detector 14 and converted into digital value by the A/D converter 13 is taken and is written in a determined area of the two-port memory 10. Thereby the current value data is sampled in the two-port memory 10 in one piece during one period of the clock signal 20.

Next, processing part B is that at the side of the positioning apparatus 1, and the execution is started when the CPU 2 of the positioning apparatus 1 detects the fall 22 of the clock signal 20 and it is always finished before the rise 21 of next clock signal 20. That is, the period of the clock signal 20 is set so that any of the required time for the processing A and the required time for the processing B is within a half period of the clock signal 20. In actual fact, the processing to access the two-port memory 10 may be finished before the rise time of next clock signal 20, and the processing not to access the two-port memory 10 is possible irrespective of the clock signal 20.

Content of the processing part B as shown in FIG. 4 is that the motor current value data is read from a determined area of the two-port memory 10 and is written in a determined area of the memory 4 of the positioning apparatus 1. The procedure that the positioning apparatus 1 reads the motor current value at the time intervals determined by the clock signal 20 has been described. FIG. 6 shows form of the motor current value data stored in the memory 4.

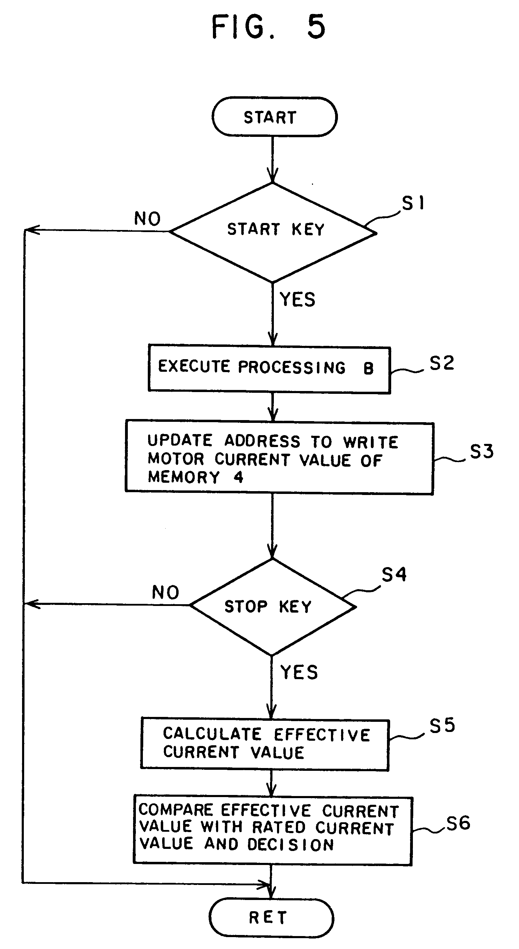

FIG. 5 shows the whole processing of the load state decision according to an embodiment of the invention. The load state decision processing shown in FIG. 5 will be described. In order to decide the load state of the motor during the positioning operation, the start key of the setting indicator 6 is pushed. Then, the process becomes "YES" at step S1, and is transferred to the processing part B of step S2. At the processing part B, as shown in FIG. 4, the motor current value data is read from the two-port memory 10 and written in the memory 4. Next, the process proceeds to step S3, and the address to write the next motor current value is updated. If this updating is finished, the process returns to the beginning, and as long as the stop key is not pushed, the above-mentioned steps are repeated, and as shown in FIG. 6, the motor current value data is recorded in the memory 4.

After lapse of the desired data taking time, a stop key of the setting indicator 6 is pushed. Then, the process proceeds from step S1 to step S4 and from step S4 to step S5, and the current value data stored in the memory 4 is read, and then the effective current value is calculated by hereinafter described means. Next, the process proceeds to step S6, and the calculated effective current value is compared with the rated current value and the load state is decided and indicated in the setting indicator 6. Or the decision result of the load state is utilized, for example, as the feedback data in the control of the motor.

Next, a calculation method for the effective current value Ie will be described.

Effective current is estimated by taking the mean square value of the current data. That is, each data is squared and the sum is estimated and divided by the number of data and its root is estimated to obtain the effective value.

That is, the root of
$$[(I_1^2 + I_2^2 + ... + I_n^2)/n]$$
may be calculated. n designates the number of data. Eventually, the effective current value Ie is expressed as follows:
$$Ie = \sqrt{(I_1^2 + I_2^2 + ... + I_n^2)/n}$$
The effective current value calculated in this manner is compared with the rated current and the decision is performed, however, since the rated current value is different depending on the capacity and condition of the motor, for example, if the rated current value is made 100% and the effective current value is expressed by %, it can be readily understood.

Time of sampling the current value or the number of sampling can be set arbitrarily in that a harmonic generating converter or the like is interposed in the clock signal thereby the signal period is made variable, and the effective value being the calculated mean square value is compared with the rated current determined corresponding to the sampled time thereby the load state can be decided. Consequently, the instantaneous maximum current value is sampled and the effective value is calculated and compared with the rated value corresponding to this, thereby the load state can be decided.

Since the torque and the calorific value of the motor is proportional to current, the decision of the load state becomes important for the thermal margin of the motor.

According to the invention as above described, using the positioning apparatus and the servo control unit, the motor current value is sampled and the effective value is calculated and compared with the rated current and the load state is decided, thereby the decision of the load state can be performed automatically.

Further according to the invention, a converting or detecting apparatus such as an oscilloscope need not be installed at the outside and the load state is decided by the positioning apparatus and the servo control unit, thereby the load state can be decided easily at low cost.

Still further according to the invention, since a converting or detecting apparatus such as an oscilloscope need not be installed at the inside and the positioning apparatus and the servo control unit already existing are provided with the load state deciding function, an apparatus need not be newly added and the load state can be decided using a conventional apparatus structure as it is.

## Claims

1. Apparatus for monitoring the load state of an electric motor (16), comprising
means (14) for detecting a load current value of said motor (16) during operation;
means (8, 10) for sampling the detected load current value at prescribed time intervals and for storing the sampled value as current value data in a memory (10);
means (2) for calculating an effective current value from the current value data and for comparing the calculated effective current value with a rated current value for deciding the load state;
characterized in that
the motor is a servomotor (16), the load state of which is controlled by a positioning apparatus (1) and a servo control unit (7) having data communication means (18) respectively so that data can be transmitted and received mutually; and
said monitoring apparatus further comprises a setting indicator (6) including a start key and a stop key, the operation of the start key starting the writing of sampled current value data from the memory (10) into a further memory (4) and the operation of the stop key starting the reading of the current value data stored in the further memory (4), the calculation of the effective current value from the current value data and the comparison of the calculated effective current value with the rated current value for deciding the load state.

2. Apparatus as set forth in claim 1,
wherein said load current value detecting means is installed in said servo control unit (7) and is constituted by a motor current detector (14) for detecting the load current of said servomotor (16) as analog quantity and an A/D converter (13) for converting the detected analog quantity into digital quantity, so that the load current of said servomotor (16) is detected and is sampled during a prescribed period.

3. Apparatus as set forth in claim 1,
wherein said sampling and storing means comprises a clock which is installed in said positioning apparatus (1), and a clock signal (20) of prescribed period is generated and outputted also to said servo control unit (7) through said data communication means (18), and a load current value being sychronized with the clock signal (20) and converted into a digital signal is sampled and stored.

4. Apparatus as set forth in claim 3,
wherein said sampling and storing means comprises a CPU (8) and the memory (10) installed in said servo control unit (7), and rise (21) of the clock signal (20) is detected by the CPU (8), and the load current value converted into a digital signal is sampled and written into the memory.

5. Apparatus as set forth in claim 4,
wherein said memory (10) is a two-port memory.

6. Apparatus as set forth in claim 4 or claim 5,
wherein said sampling and storing means comprises a further CPU (2) and the further memory (4) installed in said positioning apparatus (1), and fall (22) of the clock signal (20) is detected by the further CPU (2), and the load current value data is read from the memory (10) in said servo control unit (7) and also is written into the further memory (4) in said positioning apparatus (1).

7. Apparatus as set forth in claim 1, wherein when each sample of current value data is made $I_1$, $I_2$, ..., $I_n$, said calculating means calculates the effective current value Ie by following formula

$$Ie = \sqrt{(I_1^2 + I_2^2 + ... + I_n^2)/n}$$

wherein n: the number of samples

8. Apparatus as set forth in claim 1, wherein said decision means indicates the effective current value in % of the rated current value corresponding to 100 %.

9. Apparatus as set forth in claim 3, wherein the period of the clock signal (20) is set between 3 ms and 5 ms.

10. Apparatus as set forth in claim 3, wherein the clock signal (20) is outputted through a harmonic generating converter, and the signal period can be varied arbitrarily.

## Patentansprüche

1. Vorrichtung zur Überwachung des Belastungszustandes eines elektrischen Motors (16), der enthält
Mittel (14) zum Erkennen eines Arbeitsstromwertes des Motors (16) während des Betriebs;
Mittel (18) zum Abtasten der erkannten Arbeitsstromwerte im vorgeschriebenen Zeitintervallen und zum Speichern der abgetasteten Werte als Stromwertdaten in einem Speicher (10);
Mittel (2) zum Berechnen eines Effektivstromwertes aus den Stromwertdaten und zum Vergleichen der berechneten Effektivstromwerte mit einem Nennstromwert zum Bestimmen des Belastungszustandes;
gekennzeichnet dadurch, daß
der Motor ein Servomotor (16) ist, dessen Belastungszustand gesteuert wird durch eine Positionierungsvorrichtung (1) und eine Servosteuereinheit (7), die entsprechende Datenkommunikationsmittel (18) aufweist, so daß Daten wechselseitig übertragen und empfangen werden können und
die Überwachungseinrichtung weiter einen Stellanzeiger 6, der eine Starttaste und eine Stopptaste enthält, aufweist, die Bedienung der Starttaste das Schreiben von abgetasteten Stromwertdaten von einem Speicher (10) in einen weiteren Speicher (4) auslöst und die Bedienung der Stopptaste das Lesen der Stromwertdaten, die in dem weiteren Speicher 4 gespeichert sind, die Berechnung der Effektivstromwerte aus den Stromwertdaten und den Vergleich der berechneten Effektivstromwerte mit den Nennstromwerten zum Bestimmen des Belastungszustandes auslöst.

2. Vorrichtung nach Anspruch 1, bei der das Arbeitsstromwerterkennungsmittel in der Servosteuereinheit (7) untergebracht ist und durch einen Motorstromdetektor (14) zur Erkennung des Arbeitsstroms des Servomotors 16 als analoges Maß und einen A/D-Wandler (13) zum Umrechnen des erkannten analogen Maßes in ein digitales Maß, gebildet wird, so daß der Arbeitsstrom des Servomotors (16) während einer vorgeschriebenen Periode erkannt und abgetastet wird.

3. Vorrichtung nach Anspruch 1, bei der die Abtast- und Speichereinrichtung einen Taktgeber aufweist, welcher in der Positionierungsvorrichtung (1) untergebracht ist und ein Taktsignal (20) der vorgeschriebenen Periode erzeugt und auch an die Servosteuereinheit (7) durch die Datenkommunikationsmittel (8) durch das Datenkommunikationsmittel (18) ausgegeben wird, und ein Arbeitsstromwert, der mit dem Taktsignal (20) synchronisiert und in ein digitales Signal umgerechnet wird, abgetastet und gespeichert wird.

4. Vorrichtung nach Anspruch 3, bei der die Abtast- und Speichereinrichtung eine CPU (8) aufweist und der Speicher (10) in der Servosteuereinheit (7) untergebracht ist, und Anstieg (21) des Taktsignals (20) durch die CPU (8) erkannt wird und der in ein Digitalsignal umgerechnete Arbeitsstromwert abgetastet und in den Speicher geschrieben wird.

5. Vorrichtung nach Anspruch 4, bei der der Speicher (10) ein Zweitorspeicher ist.

6. Vorrichtung nach Anspruch 4 oder 5, bei der die Abtast- und Speichereinrichtung eine weitere CPU (2) und einen weiteren Speicher (4) enthält, die in der Positionsnierungsvorrichtung (1) untergebracht sind, und Abstieg (22) des Taktsignals (20) durch die weitere CPU (2) erkannt wird und die Arbeitsstromwertdaten von dem Speicher (10) in der Servosteuereinheit (7) gelesen und auch in den weiteren Speicher (4) in der Positionsnierungsvorrichtung (1) geschrieben werden.

**7.** Vorrichtung nach Anspruch 1,
bei der jeder Abtastwert der Stromwertdaten einen Wert $I_1$, $I_2$, ..., $I_n$ bildet, die Berechnungseinrichtung den Effektivstromwert le nach folgender Formal berechnet

$$le = \sqrt{(I_1{}^2 + I_2{}^2 + ... + I_n{}^2)/n}$$

worin in die Anzahl der Abtastwerte bedeutet.

**8.** Vorrichtung nach Anspruch 1, bei der das Bestimmungsmittel den Effektivstromwert in % des Nennstromwertes entsprechend zu 100 % anzeigt.

**9.** Vorrichtung nach Anspruch 3, bei der die Periode des Taktsignals (20) zwischen 3 ms und 5 ms beträgt.

**10.** Vorrichtung nach Anspruch 3, bei der das Taktsignal (20) durch einen Frequenzvervielfachungswandler ausgegeben wird und die Signalperiode beliebig variiert werden kann.

**Revendications**

**1.** Dispositif pour contrôler l'état de charge d'un moteur électrique (16), comprenant :

un moyen (14) pour détecter une valeur de courant de charge dudit moteur (16) pendant le fonctionnement ;

un moyen (8, 10) pour échantillonner la valeur de courant de charge détectée à des intervalles de temps prescrits et pour mémoriser la valeur échantillonnée, en tant que donnée de valeur de courant, dans une mémoire (10);

un moyen (2) pour calculer une valeur de courant réelle à partir de la donnée de valeur de courant et pour comparer la valeur de courant réelle calculée avec une valeur de courant nominale pour élaborer une décision concernant l'état de charge ;

caractérisé en ce que

le moteur est un servomoteur (16) dont l'état de charge est commandé par un appareil de positionnement (1) et une unité de servocommande (7) ayant respectivement un moyen de communication de données (18), afin de pouvoir se transmettre et recevoir mutuellement des données ; et

en ce que ledit dispositif de contrôle comprend en outre un indicateur de réglage (6) comprenant une touche marche et une touche arrêt, l'actionnement de la touche marche lançant l'écriture de la donnée de valeur de courant échantillonnée depuis la mémoire (10) vers une autre mémoire (4), et l'actionnement de la touche arrêt lançant la lecture de la donnée de valeur de courant mémorisée dans l'autre mémoire (4), le calcul de la valeur de courant réelle à partir de la donnée de valeur de courant, et la comparaison de la valeur de courant réelle calculée avec la valeur de courant nominale pour élaborer une décision concernant l'état de charge.

**2.** Dispositif selon la revendication 1,
dans lequel ledit moyen de détection de valeur de courant de charge est installé dans ladite unité de servocommande (7) et est constitué par un détecteur de courant moteur (14) pour détecter le courant de charge dudit servomoteur (16) en tant que grandeur analogique, et par un convertisseur analogique/numérique (13) pour convertir la grandeur analogique détectée en une grandeur numérique, afin que le courant de charge dudit servomoteur (16) soit détecté et échantillonné pendant une période prescrite.

**3.** Dispositif selon la revendication 1,
dans lequel ledit moyen d'échantillonnage et de mémorisation comprend une horloge qui est installée dans ledit appareil de positionnement (1), un signal d'horloge (20) de période prescrite est produit et fourni également à ladite unité de servocommande (7) par l'intermédiaire dudit moyen de communication de données (18), et une valeur de courant de charge, synchronisée avec le signal d'horloge (20) et convertie en un signal numérique, est échantillonnée et mise en mémoire.

**4.** Dispositif selon la revendication 3,
dans lequel ledit moyen d'échantillonnage et de mémorisation comprend une CPU (unité centrale de traitement) (8) et la mémoire (10) installée dans ladite unité de servocommande (7), la montée (21) du signal d'horloge (20) est détectée par la CPU (8) et la valeur de courant de charge convertie en un signal numérique est échantillonnée et écrite dans la mémoire.

**5.** Dispositif selon la revendication 4,
dans lequel ladite mémoire (10) est une mémoire à deux accès.

**6.** Dispositif selon la revendication 4 ou la revendication 5,
dans lequel ledit moyen d'échantillonnage et de mémorisation comprend une autre CPU (2) et l'autre mémoire (4) installée dans ledit appareil de positionnement (1), la descente (22) du signal d'horloge (20) est détectée par l'autre CPU (2), et la donnée de valeur de courant de charge est lue à partir de la mémoire (10) de ladite unité de servocommande (7) et également écrite dans l'autre mémoire (4) dans ledit appareil de positionnement (1).

7.  Dispositif selon la revendication 1,
    dans lequel, lorsque chaque échantillon de données de valeur de courant est désigné par $I_1$, $I_2$, ..., $I_n$, ledit moyen de calcul calcule la valeur de courant réelle le par la formule suivante

    $$Ie = \sqrt{(I_1^2 + I_2^2 + ... + I_n^2)/n}$$

    dans laquelle n est le nombre d'échantillons.

8.  Dispositif selon la revendication 1,
    dans lequel ledit moyen de décision indique la valeur de courant réelle en % de la valeur de courant nominale, correspondant à 100 %.

9.  Dispositif selon la revendication 3,
    dans lequel la période du signal d'horloge (20) est réglée entre 3 ms et 5 ms.

10. Dispositif selon la revendication 3,
    dans lequel le signal d'horloge (20) est produit par l'intermédiaire d'un convertisseur générateur d'harmoniques, et la période du signal peut être modifiée arbitrairement.

# FIG. 7

# FIG. 8

8

FIG. 1

POSITIONING APPARATUS 1

CPU 2

BUS I/F 3

MEMORY 4

I/F 5

18

SETTING INDICATOR 6

SERVO CONTROL UNIT 7

CPU 8

BUS I/F 9

TWO-PORT MEMORY 10

CURRENT CONTROLLER 11

POWER AMPLIFIER 12

14

A/D CONVERTER 13

DETECTOR I/F 15

MOTOR 16

DETECTOR 17

EP 0 392 367 B1

# FIG. 2

CLOCK SIGNAL
20

PROCESSING A
30

PROCESSING B
40

# FIG. 3

PROCESSING A
START

READ MOTOR CURRENT VALUE
FROM A/D CONVERTER 13 AND
WRITE IT IN TWO-PORT
MEMORY 10

RET

# FIG. 4

PROCESSING B
START

READ MOTOR CURRENT VALUE
FROM TWO-PORT MEMORY 10
AND WRITE IT TO MEMORY 4

RET

# FIG. 6

| MOTOR CURRENT VALUE $I_1$ |
| MOTOR CURRENT VALUE $I_2$ |
| $\vdots$ |
| MOTOR CURRENT VALUE $I_n$ |

10

# FIG. 5

START

↓

S1 — START KEY
- NO →
- YES ↓

EXECUTE PROCESSING B — S2

↓

UPDATE ADDRESS TO WRITE MOTOR CURRENT VALUE OF MEMORY 4 — S3

↓

S4 — STOP KEY
- NO →
- YES ↓

CALCULATE EFFECTIVE CURRENT VALUE — S5

↓

COMPARE EFFECTIVE CURRENT VALUE WITH RATED CURRENT VALUE AND DECISION — S6

↓

RET